# EUROPEAN PATENT APPLICATION

(11) **EP 4 838 242 A1**
(43) Date of publication of application: **11.11.2026**
(21) Application number: 25799474.9
(22) Date of filing: 04.04.2025
(51) Int. Cl.: G01R 31/52, G01R 31/28, G01R 31/54, H05K 3/00

(54) **INSPECTION SYSTEM AND INSPECTION METHOD**

(30) Priority: 09.10.2024 JP 2024177225
(71) Applicant: MEKTEC CORPORATION, Tokyo 105-8585 (JP)
(72) Inventor: The designation of the inventor has not yet been filed
(74) Representative: Page White Farrer
(86) International application number: PCT/JP2025/013727
(87) International publication number: WO 2026/078916

(57) **Abstract**

An inspecting system and an inspection method that can easily and efficiently perform a short circuit inspection and a continuity inspection on a printed circuit board are provided. An inspecting system 1 according to an embodiment is an inspecting system for performing a short circuit inspection and a continuity inspection on a flexible printed circuit board 300. The flexible printed circuit board 300 includes a plurality of wiring parts, and each of the wiring parts includes a terminal 310, a terminal 320, and wiring 330 that electrically connects the terminal 310 with the terminal 320. The inspecting system 1 includes an inspecting jig 11 including a plurality of probes 112 capable of being brought into contact with respective terminals 310 of the plurality of wiring parts, and a short circuit jig 12 that is configured to be separated from the inspecting jig 11 and includes a first probe and a second probe electrically connected to each other. The first probe and the second probe can be respectively brought into contact with adjacent terminals 320 of the flexible printed circuit board 300.

## Description

### Technical Field

The present invention relates to an inspecting system and an inspection method, and more specifically relates to an inspecting system and an inspection method for performing a short circuit inspection and a continuity inspection on a printed circuit board.

### Background Art

A short circuit inspection and a continuity inspection have been performed on printed circuit boards such as a flexible printed circuit board. In the short circuit inspection, it is inspected whether pieces of wiring are short-circuited, and in the continuity inspection, it is inspected whether the pieces of wiring are disconnected.

Specifically, in the short circuit inspection, probes of an inspecting jig are respectively brought into contact with terminals of adjacent pieces of wiring, and occurrence of a short circuit is determined by measuring resistance between the terminals. In the continuity inspection, the probes of the inspecting jig are respectively brought into contact with both ends of each piece of the wiring, and occurrence of disconnection is determined by measuring resistance between the terminals.

Patent Literature 1 discloses an inspection method for efficiently performing a continuity inspection of a printed circuit board in a short time by using a movable probe.

### Citation List

### Patent Literature

Patent Literature 1: Japanese Patent Laid-Open No. 2018-124173

### Summary of Invention

### Technical Problem

It is an object of the present invention to provide an inspecting system and an inspection method that can easily and efficiently perform a short circuit inspection and a continuity inspection on a printed circuit board. However, the object is not limited thereto, and an object corresponding to an effect obtained by a configuration of an embodiment described later may also be an object of the present invention.

### Solution to Problem

An inspecting system according to one aspect of the present invention is an inspecting system that performs a short circuit inspection and a continuity inspection on a printed circuit board, wherein
the printed circuit board includes a plurality of wiring parts, and each of the wiring parts includes a first terminal, a second terminal, and wiring that electrically connects the first terminal and the second terminal, and
the inspecting system includes:
   an inspecting jig including a plurality of probes capable of being brought into contact with the respective first terminals of the plurality of wiring parts; and
   a short circuit jig that is configured to be separated from the inspection jig and includes a first probe and a second probe electrically connected to each other, in which the first probe and the second probe are capable of being brought into contact with the adjacent second terminals of the printed circuit board.

The inspecting system described above further includes:
a control unit that controls, in performing a short circuit inspection, the inspecting jig to bring the plurality of probes into contact with the plurality of first terminals of the printed circuit board, and controls the short circuit jig to cause the first probe and the second probe to be separated from the plurality of second terminals of the printed circuit board; and
a measuring unit that is connected to the inspecting jig to measure a resistance value between the adjacent first terminals.

In the inspecting system described above,
the control unit determines that a result of the short circuit inspection is normal if the resistance value is equal to or larger than a standard insulation resistance value.

The inspecting system described above further includes:
a control unit that controls, in performing the continuity inspection, the inspecting jig to bring the plurality of probes into contact with the plurality of first terminals of the printed circuit board, and controls the short circuit jig to bring the first probe and the second probe into contact with the respective adjacent second terminals of the printed circuit board; and
a measuring unit that is connected to the inspecting jig to measure a resistance value between the adjacent first terminals.

In the inspecting system described above,
the control unit determines that a result of the continuity inspection is normal if the resistance value is equal to or smaller than a standard continuity resistance value.

In the inspecting system described above,
the control unit controls contact/non-contact between the first probe and the second probe, and the adjacent second terminals by rotating and moving the short circuit jig.

In the inspecting system described above,
the control unit controls contact/non-contact between the plurality of probes and the plurality of first terminals by causing the inspecting jig to ascend and descend.

In the inspecting system described above,
the printed circuit board is an elongated flexible printed circuit board that electrically connects a battery of an electric vehicle with a battery monitoring unit.

An inspection method according to one aspect of the present invention is an inspection method of performing a short circuit inspection and a continuity inspection on a printed circuit board, wherein
the printed circuit board includes a plurality of wiring parts, and each of the wiring parts includes a first terminal, a second terminal, and wiring that electrically connects the first terminal and the second terminal, and
the inspection method includes:
   measuring a resistance value between adjacent first terminals in a state in which a plurality of probes of an inspecting jig are respectively brought into contact with a plurality of the first terminals of the printed circuit board, and a first probe of a short circuit jig and a second probe electrically connected to the first probe are separated from a plurality of the second terminals of the printed circuit board, and determining that a result of the short circuit inspection is normal if the resistance value is equal to or larger than a standard insulation resistance value; and
   measuring a resistance value between the adjacent first terminals in a state in which the plurality of probes of the inspecting jig are respectively brought into contact with the plurality of first terminals of the printed circuit board, and the first probe and the second probe of the short circuit jig are brought into contact with the adjacent second terminals of the printed circuit board, and determining that a result of the continuity inspection is normal if the resistance value is equal to or smaller than a standard continuity resistance value.

### Advantageous Effects of Invention

According to the present invention, it is possible to provide an inspecting system and an inspection method that can easily and efficiently perform a short circuit inspection and a continuity inspection on a printed circuit board.

### Brief Description of Drawings

[Figure 1] Figure 1 is a diagram showing a schematic configuration of an inspecting system according to an embodiment.
[Figure 2] Figure 2 is a schematic cross-sectional view along line I-I in Figure 1 in a state in which probes of an inspecting jig are separated from an FPC as an inspection target.
[Figure 3] Figure 3 is a schematic cross-sectional view along line I-I in Figure 1 in a state in which the probes of the inspecting jig are in contact with the FPC as the inspection target.
[Figure 4] Figure 4 is a schematic cross-sectional view along line II-II in Figure 1 in a state in which the probes of a short circuit jig are separated from the FPC as the inspection target.
[Figure 5] Figure 5 is a diagram showing a schematic configuration of the inspecting system according to the embodiment in a state in which the probes of the short circuit jig are in contact with the FPC as the inspection target.
[Figure 6] Figure 6 is a schematic cross-sectional view along line II-II in Figure 5.
[Figure 7] Figures 7(a) and 7(b) are perspective views showing specific configuration examples of the short circuit jig.
[Figure 8] Figure 8 is a flowchart showing an example of an FPC inspection method according to the embodiment.
[Figure 9] Figure 9(a) is a plan view of the FPC as the inspection target, and Figure 9(b) is a side view of the FPC as the inspection target.

### Description of Embodiments

The following describes an embodiment according to the present invention with reference to the drawings. In each of the drawings, constituent elements having equivalent functions are denoted by the same reference numeral. A scale ratio of each constituent element is appropriately changed so that each constituent element has a size recognizable in the drawings.

### <Flexible printed circuit board as inspection target>

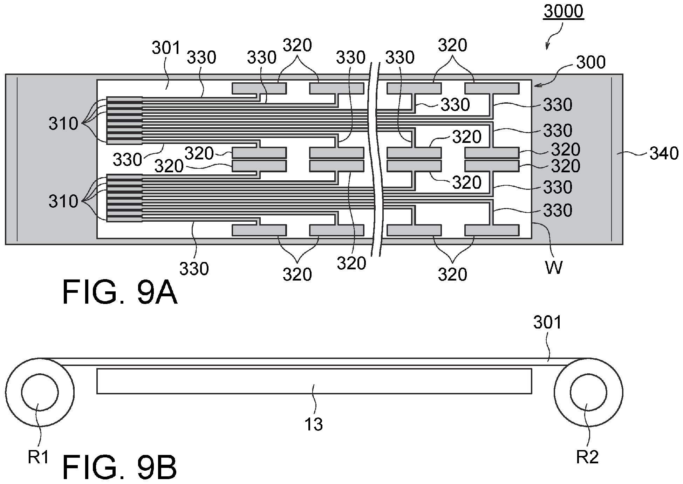

The following describes an example of a flexible printed circuit board (FPC) as an inspection target with reference to Figures 9(a) and 9(b).

An FPC roll 3000 includes an elongated insulating film 301 and a conductive film 340 formed on the insulating film 301, and both sides thereof are wound around roll shafts R1 and R2 into a roll shape. The insulating film 301 is made of an insulating material such as polyimide, polyethylene terephthalate (PET), or a liquid crystal polymer (LCP). The conductive film 340 is made of a conductive material such as electrolytic copper. On the FPC roll 3000, FPC formation regions W are arranged at predetermined intervals. When the roll shafts R1 and R2 are rotated in the same direction, the FPC formation regions W move.

The flexible printed circuit board 300 is formed in each of the FPC formation regions W of the FPC roll 3000. The flexible printed circuit board 300 is, for example, an FPC to be assembled to a battery of an electric vehicle, and electrically connects a battery including a plurality of cells with a battery monitoring unit (BMU). The flexible printed circuit board 300 shown in Figure 9(a) includes two FPCs arranged in a width direction of the FPC roll 3000, and each of the FPCs has a length of 1000 mm and a width of 120 mm, for example. A size of the printed circuit board as an inspection target is optional.

The flexible printed circuit board 300 includes a plurality of wiring parts. Each of the wiring parts includes a terminal 310, a terminal 320, and wiring 330 that electrically connects the terminal 310 with the terminal 320. As shown in Figure 9(a), a plurality of the terminals 310 are concentrated at one end part (predetermined region) of the FPC formation region W. On the other hand, the terminals 320 are arranged at distances corresponding to intervals between the cells of the battery. In a state in which the flexible printed circuit board 300 is assembled to the battery, the plurality of terminals 310 are connected to the printed circuit board on which a battery control chip and the like are implemented, and the plurality of terminals 320 are respectively connected to the plurality of cells constituting the battery.

An inspecting system 1 according to the embodiment described later performs a continuity inspection and a short circuit inspection on the flexible printed circuit board 300. In the continuity inspection, it is inspected for each wiring part whether the terminal 310 and the terminal 320 are not disconnected and are electrically connected to each other. In the short circuit inspection, it is inspected whether a short circuit occurs between adjacent wiring parts.

### <Inspecting system>

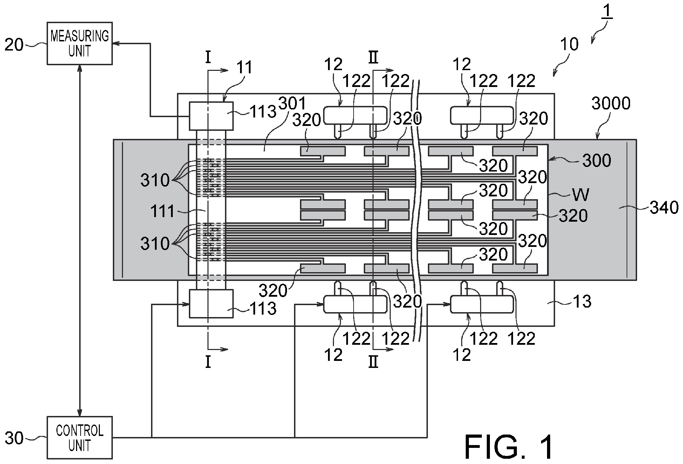

The following describes the inspecting system 1 according to the embodiment with reference to Figure 1 to Figure 6. The inspecting system 1 is an inspecting system for performing the short circuit inspection and the continuity inspection on the flexible printed circuit board 300.

The inspecting system 1 includes an inspecting device 10, a measuring unit 20, and a control unit 30. These constituent elements are connected to each other.

The inspecting device 10 includes an inspecting jig 11, a short circuit jig 12, and a stage 13.

The inspecting jig 11 includes an insulating substrate 111, a plurality of probes 112 disposed on the insulating substrate 111, and a moving mechanism 113 that causes the insulating substrate 111 to ascend and descend along a guide G. The plurality of probes 112 are disposed respectively corresponding to the plurality of terminals 310 of the flexible printed circuit board 300. Each of the probes 112 is electrically connected to the measuring unit 20 via a cable. A size of the insulating substrate 111 is, for example, 60 mm in length in a longitudinal direction of the FPC roll 3000, and 250 mm in length in a width direction of the FPC roll 3000.

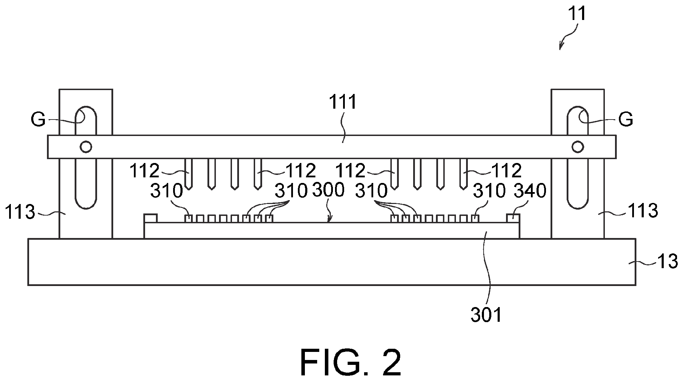

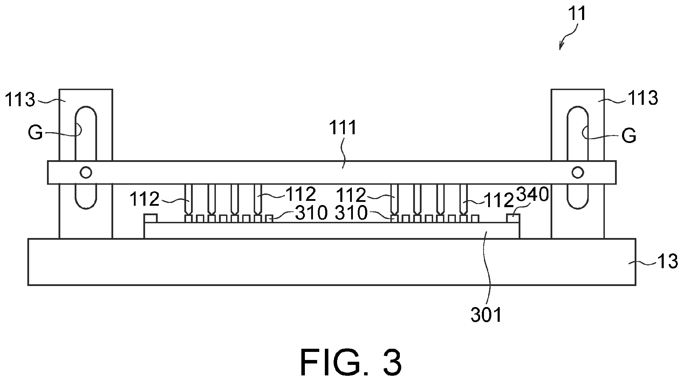

Figure 2 shows a state in which the insulating substrate 111 is positioned at a first height position, and the probes 112 are separated from the terminals 310 (non-contact state). On the other hand, Figure 3 shows a state in which the insulating substrate 111 is positioned at a second height position, and the probes 112 are in contact with the terminal 310. In this manner, in the present embodiment, the moving mechanism 113 moves the insulating substrate 111 up and down (to ascend and descend), thereby controlling contact/non-contact between the plurality of probes 112 and the plurality of terminals 310.

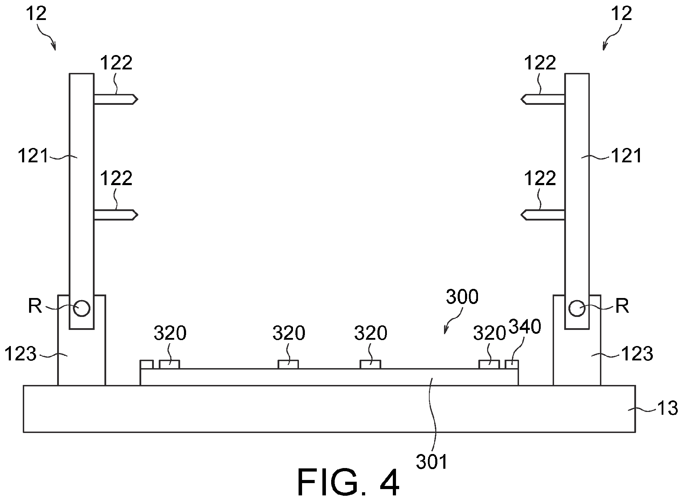

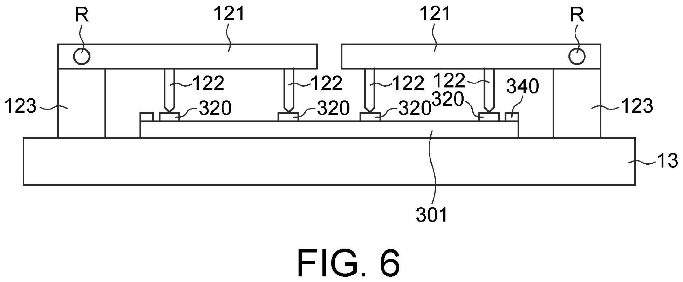

The short circuit jig 12 is a jig configured separately from the inspecting jig 11. As shown in Figure 4 and Figure 6, the short circuit jig 12 includes an insulating substrate 121, a plurality of probes 122 disposed on the insulating substrate 121, and a moving mechanism 123 that rotates and moves the insulating substrate 121 about a rotating shaft R at an end part thereof. The plurality of probes 122 are disposed respectively corresponding to the plurality of terminals 320 of the flexible printed circuit board 300. A size of the insulating substrate 121 is, for example, 100 mm in length in the longitudinal direction of the FPC roll 3000, and 170 mm in length in the width direction of the FPC roll 3000.

The short circuit jig 12 is configured to cause a short circuit between the terminals 320 of adjacent wiring parts. That is, in each short circuit jig 12 shown in Figure 1, the left and right probes 122 are electrically connected to each other via a cable (not shown). The inspecting device 10 in the present embodiment includes four short circuit jigs 12, but the number of the short circuit jigs 12 is not limited to four, and may be set according to the flexible printed circuit board 300 as the inspection target, inspection content, and the like.

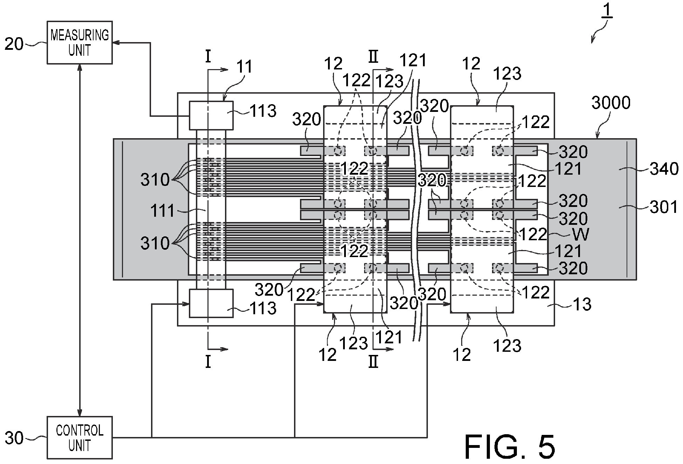

Figure 4 shows a state in which the insulating substrate 121 is in a vertical state, and each of the probes 122 is separated from the corresponding terminal 320 (non-contact state). On the other hand, Figures 5 and 6 show a state in which the insulating substrate 121 is in a horizontal state, and each of the probes 122 is in contact with the corresponding terminal 320. In this manner, in the present embodiment, the moving mechanism 123 rotates and moves the insulating substrate 121 about the rotating shaft R, thereby controlling contact/non-contact between the plurality of probes 122 and the plurality of terminals 320.

As materials of the insulating substrate 111 of the inspecting jig 11 and the insulating substrate 121 of the short circuit jig 12, for example, materials having an insulation property and heat resistance such as Bakelite and a glass epoxy resin are used.

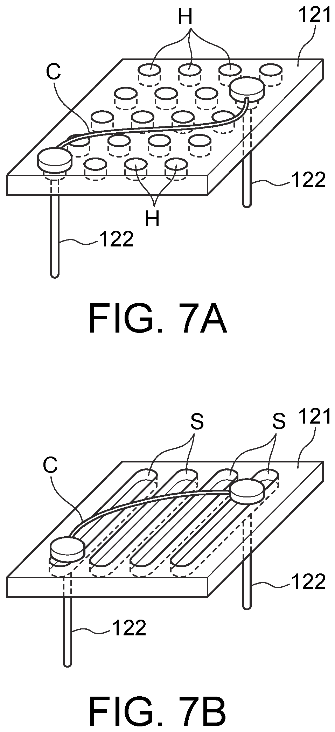

Figure 7(a) and Figure 7(b) show configuration examples of the short circuit jig 12. In the example of Figure 7(a), a plurality of through holes H are disposed at lattice point positions in the insulating substrate 121. A pair of the probes 122 electrically connected to each other via a cable C are respectively inserted into the through holes H corresponding to the terminals 320 and fixed to the insulating substrate 121. According to this example, by changing the through holes H into which the probes 122 are inserted, it is possible to support a plurality of types of flexible printed circuit boards having different positions of the terminals 320.

In the example of Figure 7(b), a plurality of slits S extending in a predetermined direction are disposed on the insulating substrate 121. The pair of probes 122 electrically connected to each other via the cable C are respectively inserted through the slits S, and fixed to the insulating substrate 121 at positions corresponding to the terminals 320. According to this example, by changing the positions of the probes 122 in the slits S, it is possible to support a plurality of types of flexible printed circuit boards having different positions of the terminals 320. Furthermore, the positions of the probes 122 can be set more precisely as compared with the example of Figure 7(a).

In the example of the short circuit jig 12 described above, the probe 122 is fixed to the insulating substrate 121 by fitting a rubber tube onto the probe 122, for example. The pair of probes 122 may be electrically connected to each other via wiring (not shown) formed on the insulating substrate 121.

The configuration of the short circuit jig 12 is not limited to the example described above. As another example, the short circuit jig 12 may be a flying probe type jig that automatically arranges probes.

The stage 13 is a placing table on which the flexible printed circuit board 300 as the inspection target is placed. In the present embodiment, the inspecting jig 11 and the short circuit jig 12 are fixed to the stage 13. The inspecting jig 11 and/or the short circuit jig 12 may be fixed to a fixing part (not shown) other than the stage 13.

In the inspecting device 10 according to the embodiment described above, contact/non-contact between the probe and the FPC is controlled by vertical movement by the inspecting jig 11, and by rotational movement by the short circuit jig 12. However, the embodiment is not limited thereto. For example, the inspecting jig 11 may be rotated and moved like the short circuit jig 12 to control contact between the probe 112 and the terminal 310. Alternatively, the short circuit jig 12 may be vertically moved like the inspecting jig 11 to control contact between the probe 122 and the terminal 320.

### <Measuring unit>

The measuring unit 20 is electrical inspecting equipment configured to perform a short circuit inspection and a continuity inspection. For example, the measuring unit 20 includes an insulation resistance tester for a short circuit inspection and a resistance tester for a continuity inspection. A resistance value may be measured by using a two-terminal method or a four-terminal method.

### <Control unit>

The control unit 30 controls the inspecting jig 11, the short circuit jig 12, and the measuring unit 20. The control unit 30 is, for example, an information processing device such as a notebook computer or a tablet terminal.

The control unit 30 controls the moving mechanism 113 of the inspecting jig 11 to control the height position of the insulating substrate 111. Specifically, in performing the short circuit inspection and the continuity inspection, the control unit 30 controls the moving mechanism 113 of the inspecting jig 11 to lower the insulating substrate 111, and brings the probes 112 into contact with the terminals 310 of the flexible printed circuit board 300.

In performing the short circuit inspection, the control unit 30 controls the moving mechanism 123 of the short circuit jig 12 to set the insulating substrate 121 in the vertical state, and cause the probes 122 to be separated from the terminals 320 of the flexible printed circuit board 300. On the other hand, in performing the continuity inspection, the control unit 30 controls the moving mechanism 123 of the short circuit jig 12 to rotate the insulating substrate 121 about the rotating shaft R into the horizontal state, and brings the probes 122 into contact with the terminals 320 of the flexible printed circuit board 300.

In performing the short circuit inspection, the control unit 30 controls the measuring unit 20 to measure insulation resistance between the probes 112 that are in contact with the adjacent terminals 310, and receives a measurement result. The control unit 30 then determines that the short circuit inspection is normal when an insulated state is found. In performing the continuity inspection, the control unit 30 controls the measuring unit 20 to measure resistance between the probes 112 that are in contact with the adjacent terminals 310, and receives a measurement result. The control unit 30 then determines that the continuity inspection is normal when a continuity state is found.

In the embodiment described above, the flexible printed circuit board is used as the inspection target, but the embodiment is not limited thereto. Another type of printed circuit board such as a rigid wiring board may also be used as the inspection target.

In the embodiment described above, inspection targets are the flexible printed circuit boards 300 formed in the plurality of FPC formation regions W of the FPC roll 3000, but the embodiment is not limited to a roll format. For example, an inspection target of the inspecting system in the present embodiment may be a panel or a single piece of flexible printed circuit board.

In the embodiment described above, the inspection target is the flexible printed circuit board, but the embodiment is not limited thereto. The inspection target may be another type of printed circuit board such as a rigid substrate.

### <Working effect>

With the inspecting system 1 in the present embodiment, by using the short circuit jig 12 that can cause a short circuit between the terminals 320 of the adjacent wiring parts, the short circuit inspection and the continuity inspection on the flexible printed circuit board 300 can be easily and efficiently performed.

In a case where the inspecting jig 11 and the short circuit jig 12 are integrally configured as a jig, a size of the jig is increased corresponding to the size (the length and the like) of the flexible printed circuit board 300 as the inspection target. However, in the present embodiment, the short circuit jig 12 is configured to be separated from the inspecting jig 11. Due to this, even if the size of the flexible printed circuit board 300 as the inspection target is increased, the size of the jig can be prevented from being increased. As a result, the size of the inspecting device 10 can be reduced, and production cost can also be reduced.

Furthermore, since the short circuit jig 12 can be manufactured at low cost, even if the flexible printed circuit board 300 as the inspection target is elongated, it can be handled easily and at low cost.

### <Inspection method>

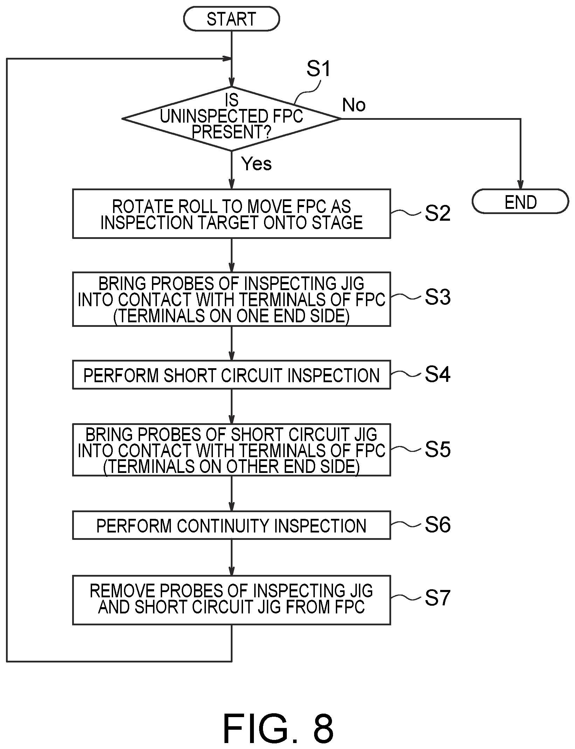

The following describes an inspection method for the printed circuit board according to the embodiment with reference to the flowchart in Figure 8. In an initial state, the probes 112 of the inspecting jig 11 and the probes 122 of the short circuit jig 12 are separated from the terminals 310 and 320 of the flexible printed circuit board 300.

Step S1: It is determined whether an uninspected flexible printed circuit board (FPC) is present in the FPC roll 3000. If the uninspected flexible printed circuit board 300 is present (Yes at S1), the process proceeds to Step S2. Otherwise, the process ends.

Step S2: The roll (rotating shaft R) of the FPC roll 3000 is rotated to move the FPC as the inspection target onto the stage 13 of the inspecting device 10.

Step S3: The probes 112 of the inspecting jig 11 are brought into contact with the terminals 310 of the flexible printed circuit board 300. Specifically, the plurality of probes 112 of the inspecting jig 11 are brought into contact with the plurality of terminals 310 of the flexible printed circuit board 300, respectively. For example, the control unit 30 controls the moving mechanism 113 of the inspecting jig 11 to lower the insulating substrate 111, and brings the probes 112 into contact with the terminals 310 of the flexible printed circuit board 300.

Step S4: The short circuit inspection is performed on the flexible printed circuit board 300. Specifically, the measuring unit 20 measures a resistance value between the adjacent terminals 310. For example, a constant voltage is applied to the adjacent wiring parts via the probes 112 of the inspecting jig 11, and a current value flowing between the wiring parts is detected. Based on a resistance value obtained from an applied voltage value and the detected current value, it is determined whether the resistance value indicates insulation resistance. That is, if the resistance value is equal to or larger than a standard insulation resistance value, the control unit 30 determines that a short circuit has not occurred between the adjacent wiring parts and a result of the short circuit inspection is normal. On the other hand, if the resistance value is smaller than the standard insulation resistance value, it is determined that the result is abnormal. The standard insulation resistance value is, for example, 10⁶ Ω to 10¹⁰ Ω. The determination result may be displayed on a display (not shown) of the control unit 30, or may be stored in a memory (not shown) of the control unit 30.

Step S5: The probes 122 of the short circuit jig 12 are brought into contact with the terminals 320 of the flexible printed circuit board 300. Specifically, the two probes 122 (a first probe and a second probe), which are electrically connected to each other and included in the short circuit jig 12, are brought into contact with the adjacent terminals 320 of the flexible printed circuit board 300, respectively. Accordingly, loop wiring in which the two wiring parts are electrically connected on the terminal 320 side is formed.

Step S6: The continuity inspection is performed on the flexible printed circuit board 300. Specifically, the measuring unit 20 measures a resistance value between the adjacent terminals 310. For example, a constant current is applied to the two adjacent wiring parts (loop wiring) that are electrically connected at the terminals 320 via the probes 112 of the inspecting jig 11, and a voltage value between the terminals 310 is detected. Based on a resistance value obtained from the applied current value and the detected voltage value, it is determined whether the resistance value indicates continuity resistance. That is, if the resistance value is equal to or smaller than a standard continuity resistance value, the control unit 30 determines that disconnection has not occurred between the two adjacent wiring parts, and the result of the continuity inspection is normal. On the other hand, if the resistance value is larger than the standard continuity resistance value, it is determined that the result of the continuity inspection is abnormal. The standard continuity resistance value is, for example, 10⁻³ Ω to 10⁻¹ Ω. The determination result may be displayed on the display (not shown) of the control unit 30, or may be stored in the memory (not shown) of the control unit 30.

Step S7: The probes 112 and 122 of the inspecting jig 11 and the short circuit jig 12 are removed from the flexible printed circuit board 300. For example, the control unit 30 controls the moving mechanism 113 of the inspecting jig 11 to raise the insulating substrate 111, and controls the moving mechanism 123 of the short circuit jig 12 to rotate the insulating substrate 121 about the rotating shaft R into the vertical state. After performing Step S7, the process returns to Step S1, and it is determined whether the uninspected flexible printed circuit board 300 is present.

As described above, in the inspection method according to the present embodiment, in performing the short circuit inspection, the plurality of probes 112 of the inspecting jig 11 are brought into contact with the plurality of terminals 310 of the flexible printed circuit board 300, and the pair of probes (the first probe and the second probe) electrically connected to each other in the short circuit jig 12 are separated from the plurality of terminals 320 of the flexible printed circuit board 300. In this state, a resistance value between the adjacent terminals 310 is measured. If the resistance value is equal to or larger than the standard insulation resistance value, it is determined that the result of the short circuit inspection is normal. On the other hand, if the resistance value is smaller than the standard insulation resistance value, it is determined that the result of the short circuit inspection is abnormal. In this manner, in the present embodiment, the short circuit inspection is performed in a state in which the short circuit jig 12 is separated from the terminals 320 of the flexible printed circuit board 300.

In the inspection method according to the embodiment described above, in performing the continuity inspection, the plurality of probes 112 of the inspecting jig 11 are brought into contact with the plurality of terminals 310 of the flexible printed circuit board 300, and the pair of probes (the first probe and the second probe) electrically connected to each other in the short circuit jig 12 are brought into contact with the adjacent terminals 320 of the flexible printed circuit board 300. In this state, a resistance value between the adjacent terminals 310 is measured. If the resistance value is equal to or smaller than the standard continuity resistance value, it is determined that the result of the continuity inspection is normal. On the other hand, if the resistance value is larger than the standard continuity resistance value, it is determined that the result of the continuity inspection is abnormal. In this manner, in the present embodiment, the continuity inspection is performed in a state in which the short circuit jig 12 is in contact with the terminals 320 of the flexible printed circuit board 300. When the adjacent terminals 320 are short-circuited by the short circuit jig 12, the adjacent wiring parts are connected on the terminal 320 side to form a single piece of wiring (loop wiring). By measuring the resistance value between the terminals 310 in a state in which the loop wiring is formed, the continuity inspection can be collectively performed on the plurality of wiring parts constituting the loop wiring.

The inspection method described above is merely an example, and can be variously modified. For example, the continuity inspection may be performed first, and the short circuit inspection may be performed thereafter. In this case, content of Step S5 (the probes 122 of the short circuit jig 12 are brought into contact with the terminals 320 of the flexible printed circuit board 300) is performed at Step S3, and content of Step S6 (continuity inspection) is performed thereafter. Instead of Step S5, a step of removing the probes 122 of the short circuit jig 12 from the terminals 320 of the flexible printed circuit board 300 is performed, and content of Step S4 (short circuit inspection) is performed.

Based on the above description, those skilled in the art may conceive additional effects and various modifications of the present invention, but aspects of the present invention are not limited to the individual embodiments described above. Constituent elements in the different embodiments may be appropriately combined. Various additions, modifications, and partial deletions may be made without departing from the conceptual spirit and scope of the present invention as derived from the content defined in the claims and equivalents thereof.

### Reference Signs List

1 inspecting system
10 inspecting device
11 inspecting jig
111 insulating substrate
112 probe
113 moving mechanism
12 short circuit jig
121 insulating substrate
122 probe
123 moving mechanism
13 stage
20 measuring unit
30 control unit
300 flexible printed circuit board
301 insulating film
310, 320 terminal
330 wiring
340 conductive film
3000 FPC roll
C cable
G guide
H through hole
R rotating shaft
R1, R2 roll shaft
S slit
W FPC formation region

## Claims

1. An inspecting system that performs a short circuit inspection and a continuity inspection on a printed circuit board, wherein
the printed circuit board includes a plurality of wiring parts, and each of the wiring parts includes a first terminal, a second terminal, and wiring that electrically connects the first terminal with the second terminal, and
the inspecting system comprises:
an inspecting jig including a plurality of probes capable of being brought into contact with the respective first terminals of the plurality of wiring parts; and
a short circuit jig that is configured to be separated from the inspection jig and includes a first probe and a second probe electrically connected to each other, in which the first probe and the second probe are capable of being brought into contact with the adjacent second terminals of the printed circuit board.

2. The inspecting system according to claim 1, comprising:
a control unit that controls, in performing a short circuit inspection, the inspecting jig to bring the plurality of probes into contact with the plurality of first terminals of the printed circuit board, and controls the short circuit jig to cause the first probe and the second probe to be separated from the plurality of second terminals of the printed circuit board; and
a measuring unit that is connected to the inspecting jig to measure a resistance value between the adjacent first terminals.

3. The inspecting system according to claim 2, wherein the control unit determines that a result of the short circuit inspection is normal if the resistance value is equal to or larger than a standard insulation resistance value.

4. The inspecting system according to claim 1, comprising:
a control unit that controls, in performing the continuity inspection, the inspecting jig to bring the plurality of probes into contact with the plurality of first terminals of the printed circuit board, and controls the short circuit jig to bring the first probe and the second probe into contact with the respective adjacent second terminals of the printed circuit board; and
a measuring unit that is connected to the inspecting jig to measure a resistance value between the adjacent first terminals.

5. The inspecting system according to claim 4, wherein the control unit determines that a result of the continuity inspection is normal if the resistance value is equal to or smaller than a standard continuity resistance value.

6. The inspecting system according to any one of claims 2 to 5, wherein the control unit controls contact/non-contact between the first probe and the second probe, and the adjacent second terminals by rotating and moving the short circuit jig.

7. The inspecting system according to any one of claims 2 to 5, wherein the control unit controls contact/non-contact between the plurality of probes and the plurality of first terminals by causing the inspecting jig to ascend and descend.

8. The inspecting system according to claim 1, wherein the printed circuit board is an elongated flexible printed circuit board that electrically connects a battery of an electric vehicle with a battery monitoring unit.

9. An inspection method of performing a short circuit inspection and a continuity inspection on a printed circuit board, wherein
the printed circuit board includes a plurality of wiring parts, and each of the wiring parts includes a first terminal, a second terminal, and wiring that electrically connects the first terminal with the second terminal, and the inspection method comprises:
measuring a resistance value between the adjacent first terminals in a state in which a plurality of probes of an inspecting jig are respectively brought into contact with a plurality of the first terminals of the printed circuit board, and a first probe of a short circuit jig and a second probe electrically connected to the first probe are separated from a plurality of the second terminals of the printed circuit board, and determining that a result of the short circuit inspection is normal if the resistance value is equal to or larger than a standard insulation resistance value; and
measuring a resistance value between the adjacent first terminals in a state in which the plurality of probes of the inspecting jig are respectively brought into contact with the plurality of first terminals of the printed circuit board, and the first probe and the second probe of the short circuit jig are brought into contact with the adjacent second terminals of the printed circuit board, and determining that a result of the continuity inspection is normal if the resistance value is equal to or smaller than a standard continuity resistance value.
